# EUROPEAN PATENT SPECIFICATION

(11) **EP 2 684 607 B1**
(45) Date of publication and mention of the grant of the patent: **16.01.2019**
(21) Application number: 13176050.6
(22) Date of filing: 11.07.2013
(51) Int. Cl.: B01L 3/00, G01N 1/40

(54) **Fluid analysis cartridge**
Fluidanalysekartusche
Cartouche d'analyse de fluide

(30) Priority: 12.07.2012 KR 20120076189
(43) Date of publication of application: 15.01.2014
(73) Proprietor: Samsung Electronics Co., Ltd., Gyeonggi-do 443-742 (KR)
(72) Inventor: LEE, Seung Jun, Gyeonggi-do (KR); KIM, Seung Hoon, Gyeonggi-do (KR); KI MIN, Jung, Gyeonggi-do (KR); KIM, Soo Hong, Gyeonggi-do (KR)
(74) Representative: Grünecker Patent- und Rechtsanwälte PartG mbB

(56) References cited:
- EP-A1- 1 500 937
- WO-A1-2005/088300
- WO-A1-2009/037784
- WO-A1-2009/112982
- US-A1- 2003 150 792

## Description

### BACKGROUND

### 1. Field

Apparatuses and methods consistent with exemplary embodiments relate to a cartridge to analyze a fluid sample.

### 2. Description of the Related Art

A device and a method to analyze a fluid sample are required for a variety of fields such as environmental monitoring, food inspection and medical diagnosis. In conventional methods, in order to perform inspection according to a given protocol, a skilled experimenter must manually perform various processes such as repeated injection of reagents, mixing, separation and transfer, reaction and centrifugation, any of which could lead to errors in the inspection results.

In order to solve these problems, small automated devices have been developed to rapidly analyze a substance to be inspected. In particular, a portable fluid analysis cartridge enables rapid analysis of substances without restriction as to site and may thus perform a wider variety of tasks in a wider variety of fields when a configuration and functions thereof are improved. Accordingly, there is a need for research and development of portable fluid analysis cartridges.

WO 2009/037784 A1 discloses an analytical instrument for analyzing specified components of body fluid. The analytical instrument comprises a filter unit with a glass fiber filter paper and a membrane.

WO 2005/088300 A1 discloses a fluid analysis cartridge with an introducing element, a blood cell separation element, a flow channel, and a dry assay element.

EP 1 500 937 A1 discloses an analyzer with a separation sheet having a membrane filter being configured to separate blood cell components.

WO 2009/112982 A1 discloses an apparatus with a filter element for filtering a fluid. The fluid is to be deposited either directly or via a deposition medium onto the filter element.

US 2003/0150792 A1 discloses a micro-fluidic separation device with a porous filter which has a specific surface chemistry.

It is the object of the present invention to provide a fluidic analysis cartridge that enables improved filtering results, whereby the cartridge guarantees a high quality of filtering results over a long time.

This object can be solved with the subject matter according to claim 1. Improved embodiments of the invention are the subject matter of the dependent claims.

### SUMMARY

One or more exemplary embodiments provide a fluid analysis cartridge and a method for manufacturing the same to improve user convenience and enable a wider variety of analysis.

One or more exemplary embodiments also provide a fluid analysis cartridge and a method for manufacturing the same to separate a specific substance from a fluid sample via a polymer membrane coated or filled with a functional substance.

One or more exemplary embodiments also provide a fluid analysis cartridge including an analysis unit to analyze a supplied fluid and a microchip provided with a variety of structures of at least one micro-channel providing a passage to enable the supplied fluid to method for manufacturing the same to separate a specific substance from a fluid sample via a polymer membrane coated or filled with a functional substance.

One or more exemplary embodiments also provide a fluid analysis cartridge including an analysis unit to analyze a supplied fluid and a microchip provided with a variety of structures of at least one micro-channel providing a passage to enable the supplied fluid to move the analysis unit, and a method for manufacturing the same.

In accordance with an aspect of an exemplary embodiment, there is provided a fluid analysis cartridge including an inspection unit configured to receive and inspect a fluid sample, a housing comprising at least one supply hole configured to supply the fluid sample to the inspection unit, and a filtering unit disposed in between the inspection unit and the housing in alignment with the supply hole of the housing, and configured to filter a specific substance present in the fluid sample.

The housing may further include a grabber disposed in a position opposite to the supply hole, wherein the grabber has a streamlined structure.

The housing may be formed with at least one material selected from the group consisting of polymethylmethacrylate (PMMA), polydimethylsiloxane (PDMS), polycarbonate (PC), linear low-density polyethylene (LLDPE), low-density polyethylene (LDPE), middle-density polyethylene (MDPE), high-density polyethylene (HDPE), polyvinyl alcohol, very low-density polyethylene (VLDPE), polypropylene (PP), acrylonitrile-butadiene-styrene (ABS), cycloolefin copolymers (COC), glass, mica, silica and semiconductor wafers.

A bottom surface of the housing may be bonded to an upper surface of the inspection unit.

The inspection unit may further include an inlet through which the fluid sample is supplied from the supply hole, wherein the housing is bonded to the inspection unit such that the supply hole is positioned in alignment with the inlet.

The filtering unit may include a membrane surface-coated with a functional substance configured to react with, bond to, or absorb the specific substance.

The functional substance may include a compound containing at least one of a functional group containing carbon and hydrogen such as alkanes, alkenes, alkynes or arenes, a functional group containing a halogen atom such as a halogen compound, a functional group containing oxygen such as alcohol or ether, a functional group containing nitrogen such as amine or nitrile, a functional group containing sulfur such as thiol or sulfide, and a functional group containing a carbonyl group such as carbonyl, aldehyde, ketone, carboxylic acid, ester, amide, carboxylic acid chloride, or carboxylic acid anhydride.

The filtering unit may include at least two porous membranes, each of which includes a plurality of pores, and is configured to filter a substance larger in size than the sizes of the plurality of pores.

The porous membrane may be selected from the group consisting of polycarbonate (PC), polyethersulfone (PES), polyethylene (PE), polysulfone (PS) and polyarylsulfone (PASF) polymer membranes.

The functional substance may be disposed between each of the at least two layers of porous membranes.

A porosity ratio of the at least two porous membranes may be about 1:1 to about 1:200.

The inspection unit may include a plurality of inspection chambers configured to inspect the fluid sample supplied through the inlet, and a supply channel connecting the inlet to the plurality of inspection chambers.

The supply channel may have a width of about 1 µm to about 500 µm.

The inspection unit may include an upper plate, a lower plate, and an intermediate plate inserted between the upper and lower plates, wherein each of the upper and lower plates comprise a film.

The upper and lower plates may independently include at least one film selected from the group consisting of polyethylene films such as very low-density polyethylene (VLDPE), linear low-density polyethylene (LLDPE), low-density polyethylene (LDPE), middle-density polyethylene (MDPE) and high-density polyethylene (HDPE) films, polypropylene (PP) films, polyvinyl chloride (PVC) films, polyvinyl alcohol (PVA) films, polystyrene (PS) films and polyethylene terephthalate (PET) films.

The intermediate plate may include a porous sheet.

The upper plate, the intermediate plate and the lower plate may each have a thickness of about 10 µm to about 300 µm.

The inlet, the plurality of inspection chambers and the supply channel may be formed in the intermediate plate.

The upper plate and the lower plate may be printed with a light-shielding ink, and regions of the upper plate and the lower plate corresponding to the plurality of inspection chambers may be treated with a transparent material.

The housing may include at least two supply holes and the inspection unit may include at least two inlets disposed at positions corresponding to the at least two supply holes.

In accordance with an aspect of another exemplary embodiment, there is provided an inspection unit including a plurality of inspection chambers configured to receive and inspect a fluid sample, wherein the plurality of inspection chambers are disposed in an arrangement forming at least two layers, wherein an upper layer of inspection chamber alternates with a lower layer of inspection chamber.

In accordance with an aspect of another exemplary embodiment, there is provided a fluid analysis cartridge including an inspection unit configured to receive a fluid sample and to perform a plurality of inspections on the fluid sample, and a housing comprising at least one supply hole configured to supply the fluid sample to the inspection unit, wherein the inspection unit includes an upper plate, a lower plate, and an intermediate plate inserted between the upper plate and the lower plate, wherein each of the upper and lower plates is form from a film, wherein the intermediate plate is formed from a porous sheet, and wherein the upper, intermediate, and lower plates are bonded to one another.

The intermediate plate may include an inlet through which the fluid sample is supplied from the supply hole, a plurality of inspection chambers configured to inspect the fluid sample supplied through the inlet, and a supply channel configured to connect the inlet to the inspection chambers.

### BRIEF DESCRIPTION OF THE DRAWINGS

The above and/or other aspects will become apparent and more readily appreciated from the following description of exemplary embodiments, taken in conjunction with the accompanying drawings of which:
FIG. 1 illustrates an overall outer appearance of a fluid analysis cartridge according to an exemplary embodiment;
FIG. 2A is a plan view illustrating a housing of the fluid analysis cartridge according to an exemplary embodiment;
FIGS. 2B and 2C are plan views illustrating a housing of the fluid analysis cartridge including a plurality of supply holes;
FIG. 3 is a side sectional view illustrating the fluid analysis cartridge according to an exemplary embodiment.
FIGS. 4A to 4D are side sectional views illustrating configurations of a filtering unit of the fluid analysis cartridge according to exemplary embodiments;
FIG. 5A is an exploded perspective view illustrating each layer of an inspection unit of the fluid analysis cartridge according to an exemplary embodiment;
FIG. 5B is a plan view illustrating an upper plate of the inspection unit;
FIG. 5C is a plan view illustrating a lower plate of the inspection unit.
FIGS. 6A to 6E are plan views illustrating an intermediate plate of the inspection unit of the fluid analysis cartridge according to an exemplary embodiment;
FIGS. 7A to 7D illustrate an example of a microfluidic structure formed in the intermediate plate; and
FIG. 8 is a plan view illustrating an intermediate plate including two inlets.

### DETAILED DESCRIPTION

Reference will now be made in detail to exemplary embodiments, examples of which are illustrated in the accompanying drawings, wherein like reference numerals refer to like elements throughout.

Hereinafter, a fluid analysis cartridge according to an exemplary embodiment will be described with reference to the annexed drawings.

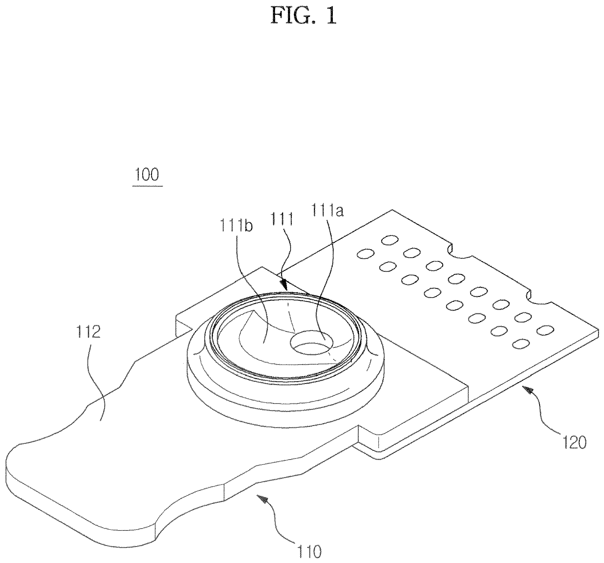

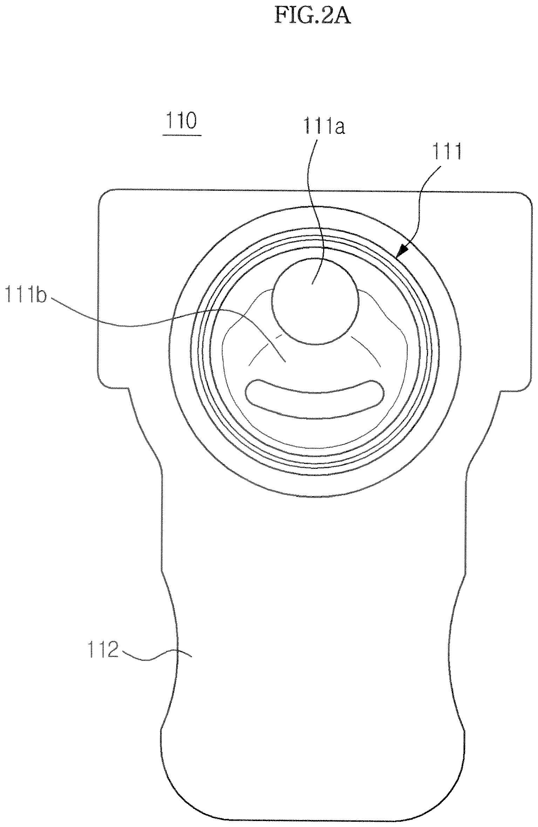

FIG. 1 illustrates an overall outer appearance of the fluid analysis cartridge according to an exemplary embodiment and FIG. 2A is a plan view illustrating a housing of the fluid analysis cartridge according to an exemplary embodiment.

Referring to FIG. 1, the fluid analysis cartridge 100 includes a housing 110 to support the fluid analysis cartridge 100 and an inspection unit 120 within which a fluid reacts with a reagent.

Referring to FIGS. 1 and 2A, the housing 110 provides a grabber 112 functioning to support the fluid analysis cartridge 100 and enable a user to grab the fluid analysis cartridge 100. The fluid analysis cartridge 100 is advantageous in that rapid inspection of fluid samples is possible at any location. Thus, users such as patients, doctors, nurses and medical technologists may inspect bio-samples obtained from the human body in sites such as homes, offices, outpatient clinics, hospital rooms, emergency rooms, operating rooms and intensive care rooms, other than a central inspecting room. Such testing is referred to as point of care testing (POCT).

However, during POCT, if the fluid analysis cartridge 100 is not firmly grasped during supply of the fluid sample, the fluid analysis cartridge 100 may be dropped. In addition, it may be dropped during transport by the user .

Accordingly, the housing 100 of the fluid analysis cartridge 100 provides a grabber 112 having a shape that enables the user to easily grab the fluid analysis cartridge 100. Referring to FIG. 1, the grabber 112 has a streamlined protrusion shape, enabling the user to stably grab the fluid analysis cartridge 100 without touching the inspection unit 120 or a fluid supplier 111.

The housing 110 also includes a fluid supplier 111 to receive and supply a fluid sample. Exemplary fluid samples, which may be analyzed through the fluid analysis cartridge 100, include, but are not limited to, bio-samples such as bodily fluids including blood, tissue fluids and lymph fluids, saliva and urine, or environmental samples to control water or soil.

As shown FIGS. 1 and 2A, the fluid supplier 111 includes a supply hole 111a through which the supplied fluid sample is fed into the inspection unit 120 and a subsidiary supply unit 111b to aid the supplying of the fluid.

As shown in FIG. 1, the supply hole 111a has a circular shape, but may have a polygonal shape, since the exemplary embodiment is not limited thereto. The user may inject the fluid sample including the analysis target into the supply hole 111a using a device such as pipet or spoid. However, the size of the supply hole 111a is limited, as the size of the fluid analysis cartridge 100 is decreased. Thus, as the size of the supply hole 111a is decreased, the difficulty in accurately injecting the fluid sample therein increases.

Accordingly, the subsidiary supply unit 111b is configured to include a surface near and/or surrounding the supply hole 111a that declines toward the supply hole 111a to enable the fluid sample dropped near the supply hole 111a to flow therein. Specifically, when the user does not accurately inject the fluid sample into the supply hole 111a and drops part of the fluid sample near the supply hole 111a, the fluid sample flows into the supply hole 111a via the declining surface of the subsidiary supply unit 111b.

Also, the subsidiary supply unit 111b aids in preventing the unintentional contamination of the fluid sample. Specifically, being disposed near and/or surrounding the supply hole 111a, the subsidiary supply unit 111b prevents the fluid sample from flowing into the inspection unit 120 or onto the grabber 112, thereby preventing the fluid sample from contaminating the fluid analysis cartridge 100 and prevents the fluid sample from contacting the user.

The housing 110 may be made of a material which is easy to mold and is chemically and biologically inactive. For example, the housing 110 may be made of a variety of materials including, but not limited to, plastic materials including acryl such as poly(methyl methacrylate) (PMMA), polysiloxane such as polydimethylsiloxane (PDMS), polycarbonate (PC), polyethylene such as linear low-density polyethylene (LLDPE), low-density polyethylene (LDPE), middle-density polyethylene (MDPE), and high-density polyethylene (HDPE), polyvinyl alcohol, very low-density polyethylene (VLDPE), polypropylene (PP), acrylonitrile-butadiene-styrene (ABS) and cycloolefin copolymers (COC), glass, mica, silica, and semiconductor wafers. Thus, any material may be used for the housing 110, so long as it has chemical and biological stability and mechanical processability.

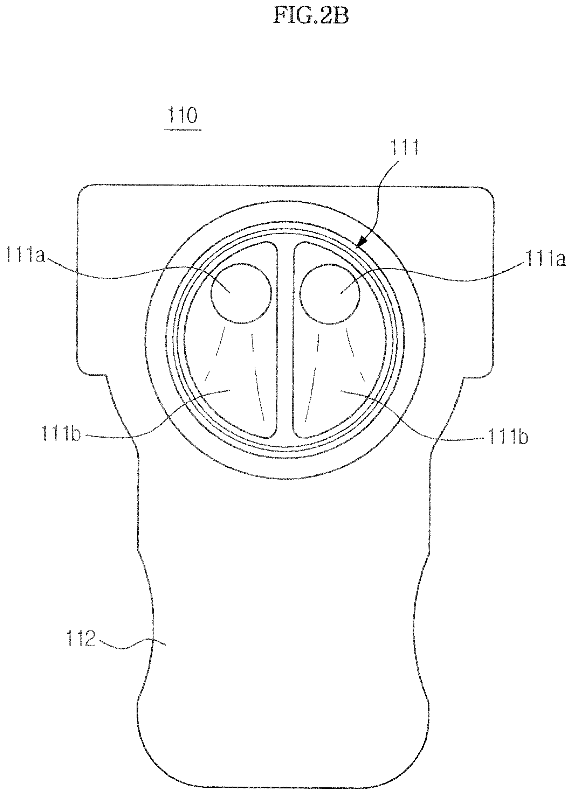

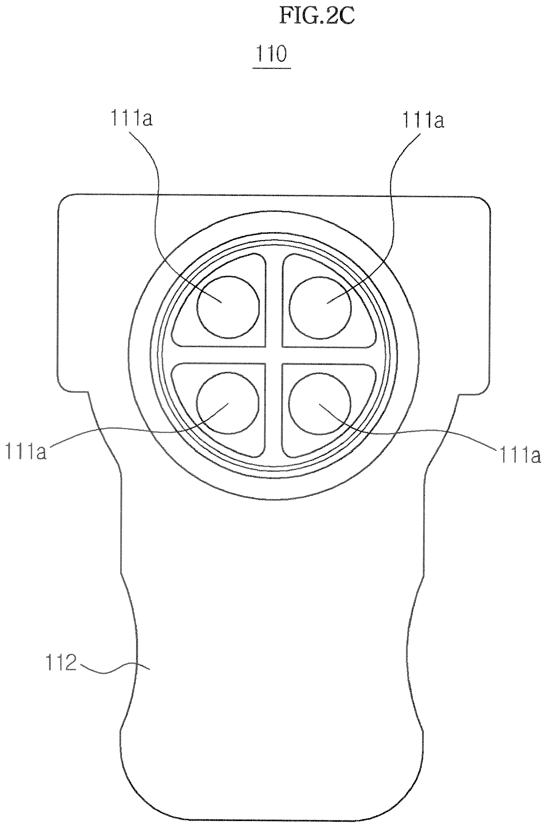

While the fluid supplier 111 shown in FIGS. 1 and 2A includes one supply hole 111a, the fluid analysis cartridge 100 may include a plurality of supply holes 111a. FIGS. 2B and 2C are plan views illustrating a housing of the fluid analysis cartridge including a plurality of supply holes 111a.

Referring to FIGS. 2B and 2C, the fluid analysis cartridge 100 according to an exemplary embodiment includes two or four supply holes 111a in the housing 110. However, the number of supply holes 111a shown in FIGS. 2B and 2C is given only for description of the exemplary embodiments are therefore not limited to the number of the supply holes 111a.

In various exemplary embodiments, the supply hole 111a may have a diameter of about 0.5 mm to about 10 mm. The supply holes having various sizes may be formed while taking into consideration total size of the fluid analysis cartridge 100, number of supply holes included therein, and the type of analyzed fluid sample.

As shown in FIGS. 2B and 2C, when a plurality of supply holes 111a are provided, different numbers of fluid samples may be simultaneously inspected in one fluid analysis cartridge 100. The different fluid samples may be of the same type while being derived from different sources, may be different types from the same or different sources, or may be the same type from the same source but having different states.

For example, as shown in FIG. 2B, when the number of supply holes 111a is two, blood of a patient may be supplied to one supply hole 111a and lymph fluid of the patient may be supplied to the other supply hole 111a. Alternatively, blood of one patient may be supplied to one supply hole 111a and blood of another patient may be supplied to the other supply hole 111a.

Also, as shown in FIG. 2C, when the number of supply holes 111a is four, four blood samples collected at predetermined intervals from the same patient may be supplied to the respective supply holes 111a, or blood samples collected from different patients may be supplied to the respective supply holes 111a.

It should be understood that the description associated with FIGS. 2B and 2C is given only as an example to which the exemplary embodiments are applied. Any of various fluid samples may be supplied through the plurality of supply holes 111a and may thus be subjected to various inspections. A method for inspecting the supplied fluid sample will now be described in detail.

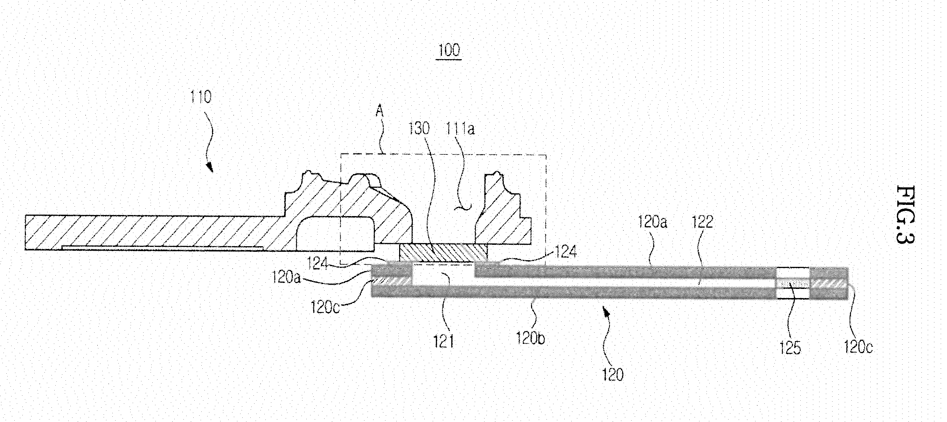

FIG. 3 is a side sectional view illustrating the fluid analysis cartridge according to an exemplary embodiment.

Referring to FIG. 3, the fluid analysis cartridge 100 has a configuration in which the inspection unit 120 is bonded to at least a portion of a bottom surface of the fluid supplier 111 of the housing 110. A pressure sensitive adhesive (PSA) 124 may be used for bonding the housing 110 to the inspection unit 120. The PSA 124 enables rapid adhesion while requiring a low pressure comparable to a finger pressure at room temperature, and does not leave residue on the respective surfaces when detached.

It should be understood that the housing 110 and the inspection unit 120 are not necessarily bonded to each other through PSA, but rather, may be bonded by a double-sided adhesive other than PSA, or may be bonded by a method in which a projection is coupled to a groove.

An area represented by the region (A) of FIG. 3 denotes the portion where the fluid sample flowing through the supply hole 111a passes through a filtering unit 130 and flows into a supply channel 122 of the inspection unit 120. The filtering unit 130 may include a polymer membrane such as polycarbonate (PC), polyethersulfone (PES), polyethylene (PE), polysulfone (PS), or polyarylsulfone (PASF), and the polymer membrane may have a porous structure to filter the fluid sample.

For example, when blood is a fluid sample and it flows through the supply hole 111a, filtering unit 130 filters out the blood cells, thereby causing only plasma or blood serum to flow into the supply channel 122. The polymer membrane may have a porosity ratio of 1:1 to 1:200 and an average pore diameter of about 0.1 µm to about 10 µm. Herein, the porosity ratio means a size ratio of pores formed in the polymer membrane, more specifically, a ratio of the smallest pore size to the largest pore size. As the porosity ratio increases, the filtering speed increases.

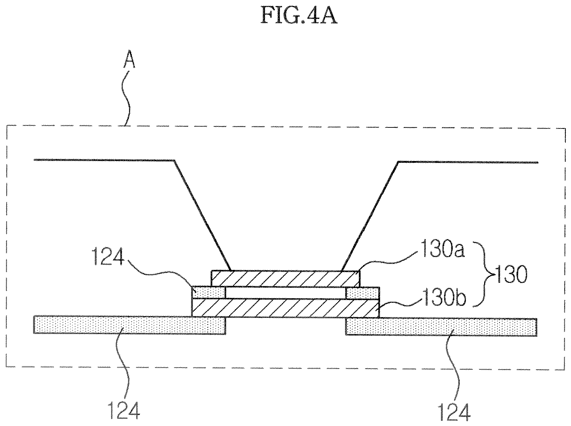

FIGS. 4A to 4D are side sectional views illustrating various configurations of a filtering unit of the fluid analysis cartridge according to exemplary embodiments.

Referring to FIG. 4A, the filtering unit 130 may include a double-layer of polymer membranes 130a and 130b. As described above, the polymer membrane functions to filter the fluid sample. When the polymer membrane includes two layers, as shown in FIG. 4A, a fluid sample passing through the first polymer membrane 130a is further filtered through the second polymer membrane 130b. Also, when a great amount of particles larger than the pore size of the polymer membrane are simultaneously supplied tearing or damage of the polymer membrane is prevented by including multiple layers.

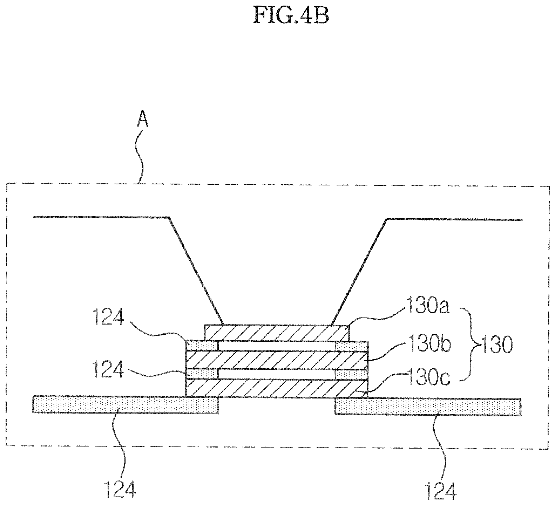

Referring to FIG. 4B, the filtering unit 130 may include a triple-layer of polymer membranes 130a, 130b and 130c. Thus, filtering function of the fluid sample is further improved and stability of the filtering unit 130 is also improved.

FIGS. 4A and 4B illustrate only examples of the filtering unit 130 including a multi-layer polymer membrane. Thus, the polymer membrane may include four or more layers, depending on the supplied fluid sample and a substance to be analyzed contained therein.

The plurality of polymer membranes 130a and 130b may be fixed in place with an adhesive 124, such as a double-sided adhesive.

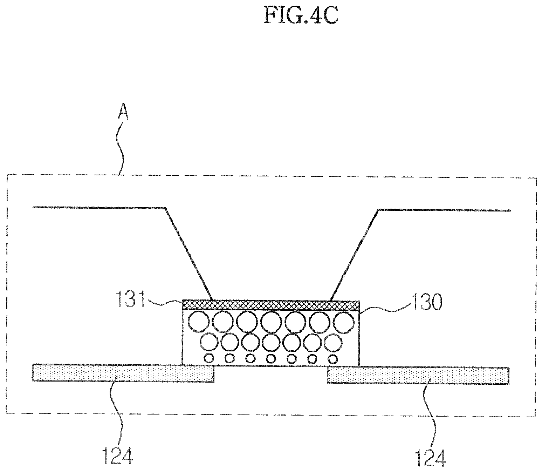

Referring to FIG. 4C, in various embodiments, the filtering unit 130 may be provided with a porous membrane having the surface of which coated with a functional substance.

The functional substance 131 may be a compound containing at least one of a first functional group containing carbon and hydrogen such as alkanes, alkenes, alkynes or arenes, a second functional group containing a halogen atom such as a halogen compound, a third functional group containing oxygen such as alcohol or ether, a fourth functional group containing nitrogen such as amine or nitrile, a fifth functional group containing sulfur such as thiol or sulfide, and a sixth functional group containing a carbonyl group such as carbonyl, aldehyde, ketone, carboxylic acid, ester, amide, carboxylic acid chloride, or carboxylic acid anhydride.

As shown in FIG. 4C, when the porous membrane is surface-coated with a functional substance 131 having a specific function, and the fluid sample passes through the porous membrane, a substance bonded to or adsorbed to the functional substance is filtered, instead of passing through the porous membrane. Accordingly, a specific substance present in the fluid sample is filtered.

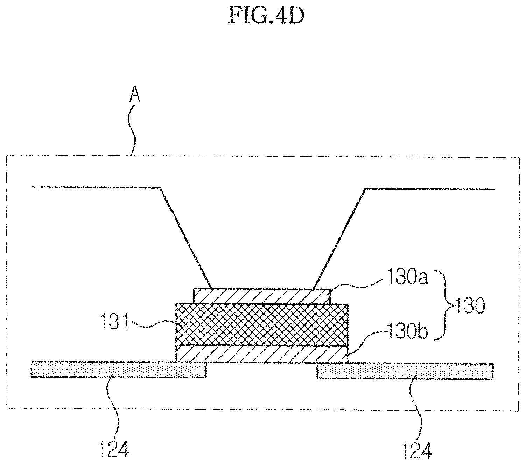

Referring to FIG. 4D, the filtering unit 130 according to an exemplary embodiment may have a configuration in which a functional substance 131 is disposed between the double-layer porous membranes 130a and 130b. For example, when boronic acid or concanavalin A is disposed between the double-layer porous membranes 130a and 130b, HbAlc may be efficiently measured from a patient's sample.

As described in FIG. 3 above, a fluid sample flows through the fluid supplier 111 of the housing 110 of the fluid analysis cartridge 100, passes through the filtering unit 130, flows into the inspection unit 120 and is subjected to various inspections in the inspection chambers 125.

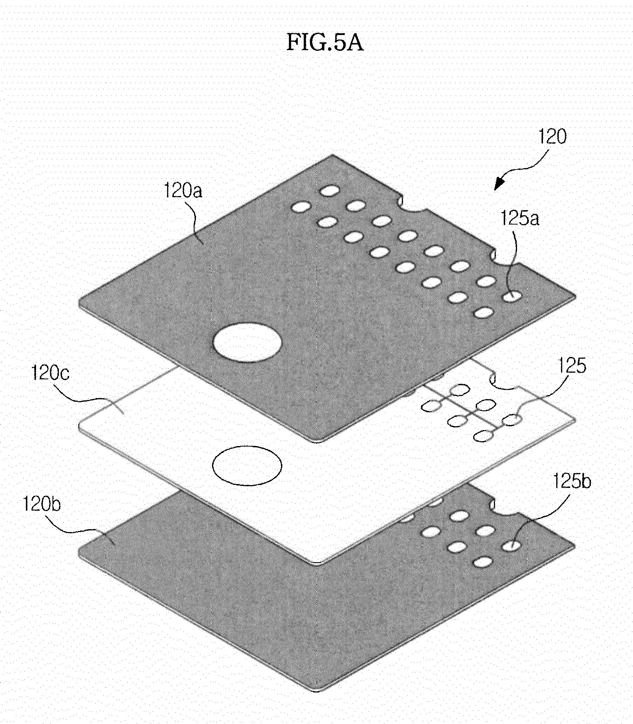

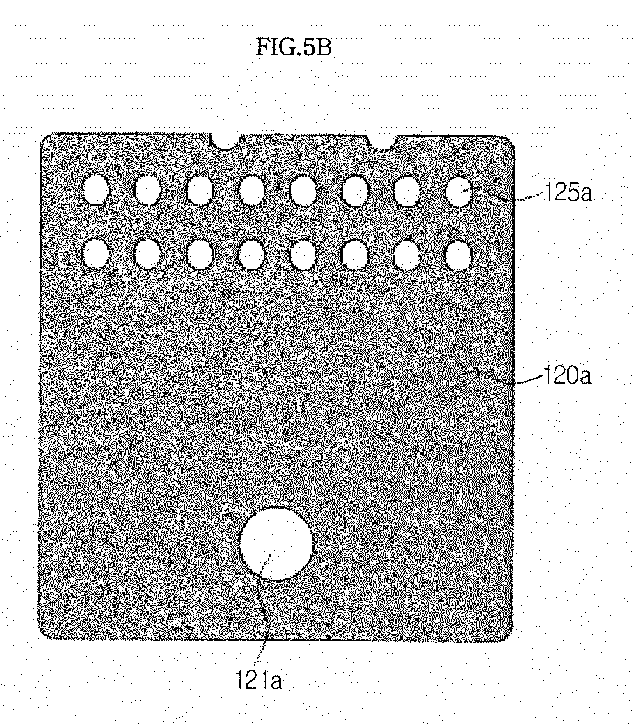

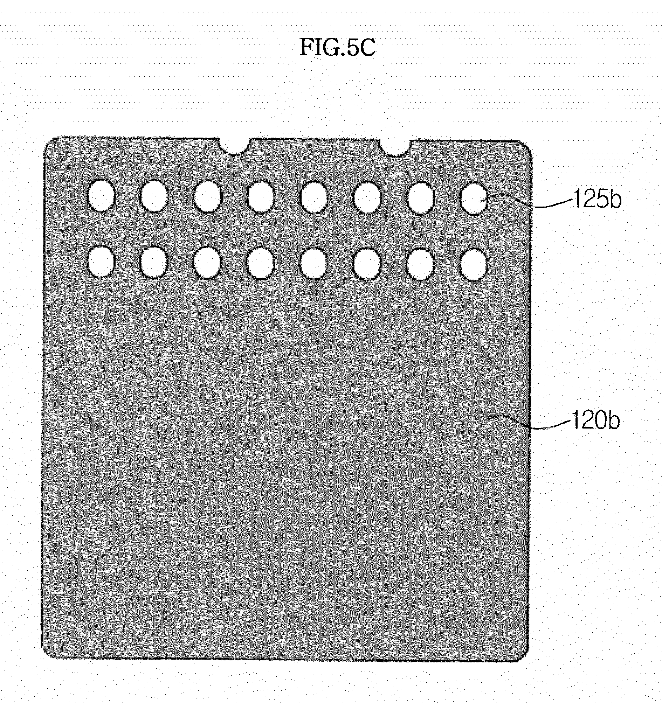

FIG. 5A is an exploded perspective view illustrating each layer of an inspection unit of the fluid analysis cartridge according to an exemplary embodiment. FIG. 5B is a plan view illustrating an upper plate of the inspection unit. FIG. 5C is a plan view illustrating a lower plate of the inspection unit.

Referring to FIG. 5A, the inspection unit 120 of the fluid analysis cartridge 100 has a configuration in which three plates 120a, 120b and 120c are connected to one another. The three plates may be divided into an upper plate 120a, a lower plate 120b and an intermediate plate 120c. The upper plate 120a and the lower plate 120b may be printed with a light-shielding ink to protect the fluid sample flowing to an inspection chamber 125 from exterior light and/or prevent errors during measurement of optical properties.

The upper plate 120a, the lower plate 120b and the intermediate plate 120c may each have a thickness of about 10µm to about 300µm, and the upper plate 120a and the lower plate 120b may be in the form of a film. The thicknesses of the upper, lower and intermediate plates are given only as an example and are therefore not limited thereto.

The film used for formation of the upper plate 120a and the lower plate 120b of the inspection unit 120 may be selected from polyethylene films such as very low-density polyethylene (VLDPE), linear low-density polyethylene (LLDPE), low-density polyethylene (LDPE), middle-density polyethylene (MDPE) and high-density polyethylene (HDPE) films, polypropylene (PP) films, polyvinyl chloride (PVC) films, polyvinyl alcohol (PVA) films, polystyrene (PS) films and polyethylene terephthalate (PET) films. However, it should be understood that these substances are given as examples of films applicable to the inspection unit 120 and any film may be used so long as it is chemically and biologically inactive and exhibits mechanical processability.

Unlike the upper plate 120a and the lower plate 120b, the intermediate plate 120c of the inspection unit 120 may be made of a porous sheet such as cellulose and may be subject to a hydrophobic treatment. Accordingly, the intermediate plate 120c may function as a vent. A detailed explanation of the intermediate plate 120c of the inspection unit 120 is provided below.

As shown in FIG. 3, the inspection unit 120 includes an inlet 121 receiving a fluid sample that passes through the filtering unit 130, a supply channel 122 to enable the fluid sample to flow therein, and a plurality of inspection chambers 125 within which the fluid sample reacts with a reagent.

Referring to FIGS. 5A to 5C, when the inspection unit 120 has a triple layered structure, an inlet 121a is formed in the upper plate 120a and a plurality of first regions 125a, corresponding to the plurality of inspection chambers 125, are disposed thereon and are treated with a transparent material. Also, disposed in the lower plate 120b are a plurality of second regions 125b, corresponding to the plurality of inspection chambers 125. The plurality of second regions 125b are treated with a transparent material to enable measurement of optical properties associated with reactions occurring in the plurality of inspection chambers 125.

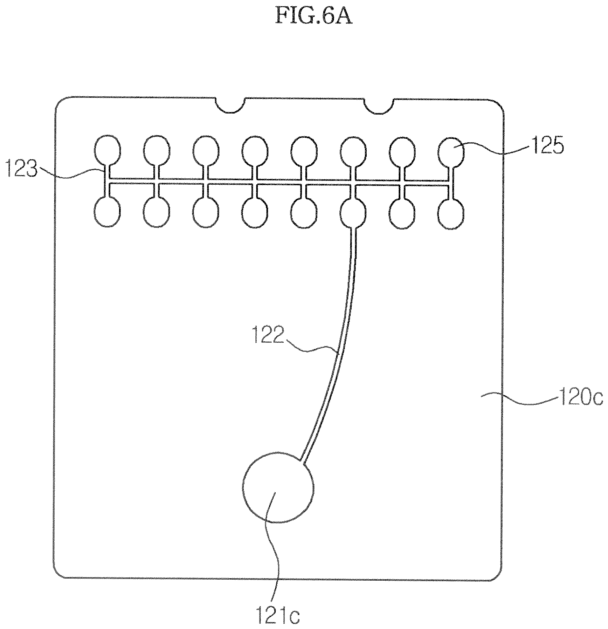

FIGS. 6A to 6E are plan views illustrating an intermediate plate of the inspection unit of the fluid analysis cartridge according to an exemplary embodiment.

Referring to FIG. 6A, the intermediate plate 120c includes an inlet 121c to supply a fluid sample. Thus, when the upper plate 120a, the intermediate plate 120c and the lower plate 120b are bonded to one another, the inlet 121a of the upper plate 120a is aligned with the inlet 121c of the intermediate plate 120c to form the inlet 121 of the inspection unit 120.

The plurality of inspection chambers 125 are formed in a location opposite to that of the inlet 121c within the intermediate plate 120c. In an exemplary embodiment, the plurality of inspection chambers 125 are formed by removing a portion of the intermediate plate 120c in a predetermined shape such as circle or polygon. As described in FIG. 3 above, since the region corresponding to the plurality of inspection chambers 125 of the upper plate 120a and the lower plate 120b is not open, an inspection chamber 125 that is configured to accommodate a fluid sample and a reagent is formed by removing a predetermined portion of the intermediate plate 120c. That is, when a hole is formed in the intermediate plate 120c, the hole may become an inspection chamber 125.

Alternatively, a micro storage container may be disposed in the region in which the intermediate plate 120c is removed and is thus used as the inspection chamber 125.

As described with reference to FIGS. 5B and 5C above, because the regions of the upper plate 120a and lower plate 120b that correspond to the plurality of inspection chambers 125 are treated with a transparent material, any reactions occurring in the plurality of inspection chambers 125 and/or reaction products thereof may be detected.

Any of a variety of reactions to analyze fluids may occur in the plurality of inspection chambers 125. In an exemplary embodiment in which blood is used as a fluid sample, a reagent which reacts with a specific component of blood (in particular, plasma) and renders color or discolors may be stored in the plurality of inspection chambers 125. Thus, color rendered in the plurality of inspection chambers 125 may be detected and represented numerically. Based on the numerical value, the presence or ratio of specific components in the blood sample may be determined.

The intermediate plate 120c may also include a supply channel 122 to supply the fluid sample to the plurality of inspection chambers 125. The supply channel 122 may also be formed by removing a portion of the intermediate plate 120c that corresponds to the supply channel 122. In various exemplary embodiments, the supply channel 122 may have a width of about 1µm to about 500 µm.

As shown in FIG. 6A, the supply channel 122 may be connect the inlet 121c to one of the plurality of inspection chambers 125. The fluid sample supplied to the inlet 121c therefore flows through the supply channel 122 and into one of the plurality of inspection chambers 125 based on capillary force. The fluid sample thereafter flows into the rest of the plurality of inspection chambers 125 through a branch channel 123 which connects the inspection chambers 125 and reacts with one or more reagents contained in the plurality of inspection chambers 125.

In this case, the inspection chamber 125 that is directly connected to the inlet 121c through the supply channel 122 may be empty or may contain a reagent or a reaction solution to preliminarily treat the fluid sample.

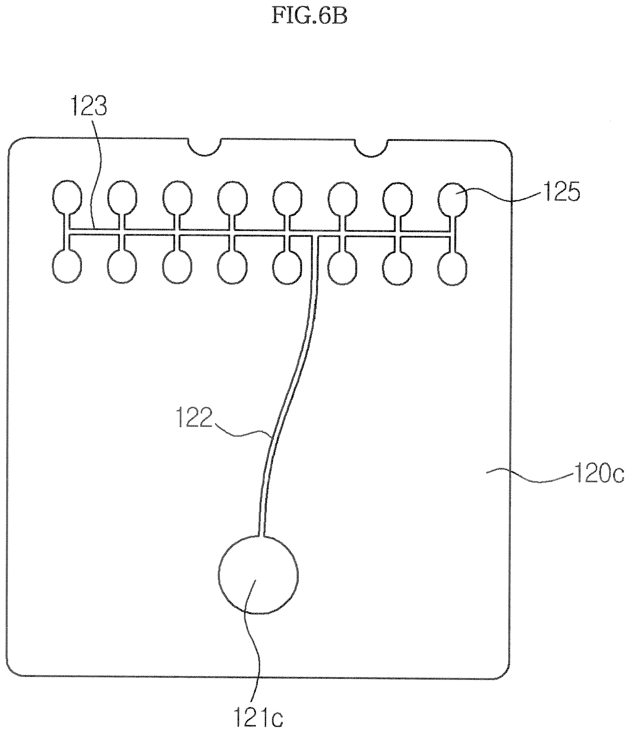

Alternatively, as shown in FIG. 6B, the supply channel 122 may be connected directly to the branch channel 123, instead of being connected to one of the plurality of inspection chambers. Thus, depending on the type of fluid sample or type of inspection being performed in the plurality of inspection chambers 125, the supply channel 122 may be connected to one of the plurality of inspection chambers 125 or to the branch channel 123.

When the upper plate 120a, the lower plate 120b and the intermediate plate 120c are attached to one another, one complete inspection unit 120 is formed. Further, when the inspection unit 120 and the housing 110 are attached to each other, the fluid analysis cartridge 100 as shown in FIGS. 1 and 2 is formed.

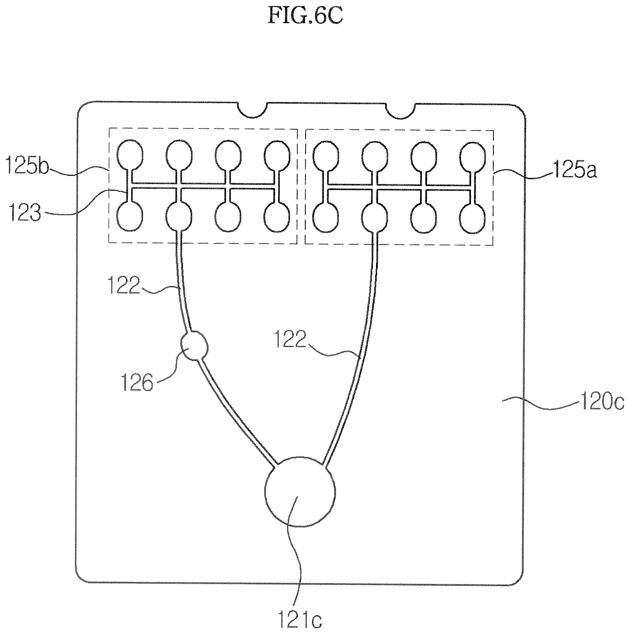

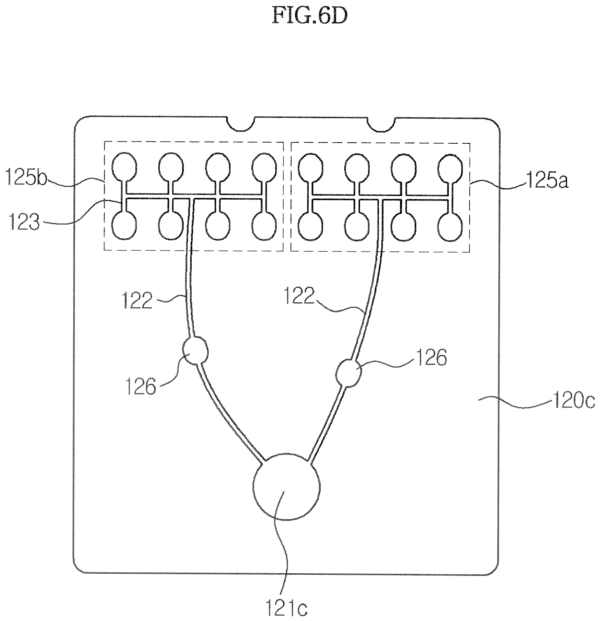

In the drawings described above, the number of supply channels 122 is one. However, as shown in FIGS. 6C and 6D, two supply channels 122 may be connected to the inlet 121c. In this case, the plurality of inspection chambers 125 may be divided into two separate inspection regions 125a and 125b. As shown, one or more of the plurality of supply channels 122 may further include an intermediate chamber 126. When the intermediate chamber 126 is formed on one of the plurality of supply channels 122, only the inspection region 125b to which the corresponding supply channel 122 is connected, is pre-treated, or a fluid sample which has undergone primary reaction may be supplied thereto.

Alternatively, as shown in FIG. 6D, intermediate chambers may be formed on both supply channels 122, and different pre-treatments may be performed in the intermediate chambers 126, or primary reaction with different reagents or reaction solutions may occur in the respective intermediate chambers 126.

In FIGS. 6C and 6D, two supply channels 122 are connected to the inlet 121c, but the exemplary embodiment is not limited thereto. That is, three or more supply channels 122 may be connected to one inlet 121c to supply fluid samples to three or more inspection regions.

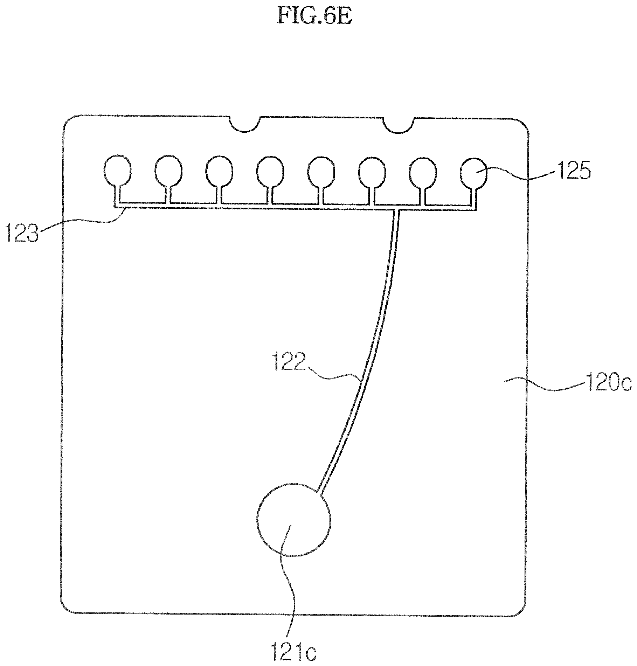

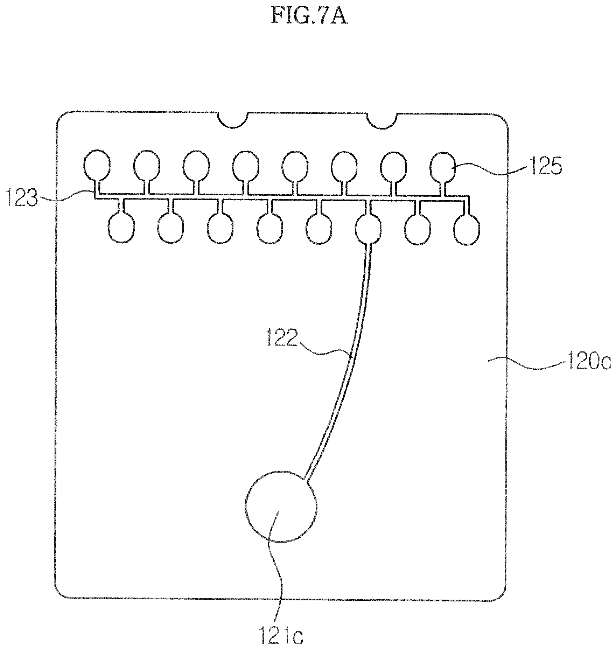

In the drawings described above, the plurality of inspection chambers 125 are arranged lengthwise to form a double-layer structure. However, the plurality of inspection chambers 125 may be arranged in a single layer structure, as shown in FIG. 6E. In this case, the transparent region of the upper plate 120a and the lower plate 120b is also formed at the position corresponding to and in alignment with the plurality of inspection chambers 125. FIGS. 7A to 7D illustrate an example of a microfluidic structure formed in the intermediate plate.

Referring to FIG. 7A, the plurality of inspection chambers 125 is arranged lengthwise to form a double-layer structure with the inspection chambers 125 arranged in upper and lower layers, thereby forming a zigzag pattern. When upper and lower layers of the plurality of inspection chambers 125 are so arranged, the fluid samples may be supplied at predetermined time intervals.

As shown in FIG. 7A, when the fluid sample passes through one of the plurality of inspection chambers 125 and flows into the remaining inspection chambers 125, the inspection chamber 125 that the fluid sample first passes through may contain a reagent or reaction solution to pre-treat the fluid sample. Alternatively, the inspection chamber 125 connected to the supply channel 122 may be empty.

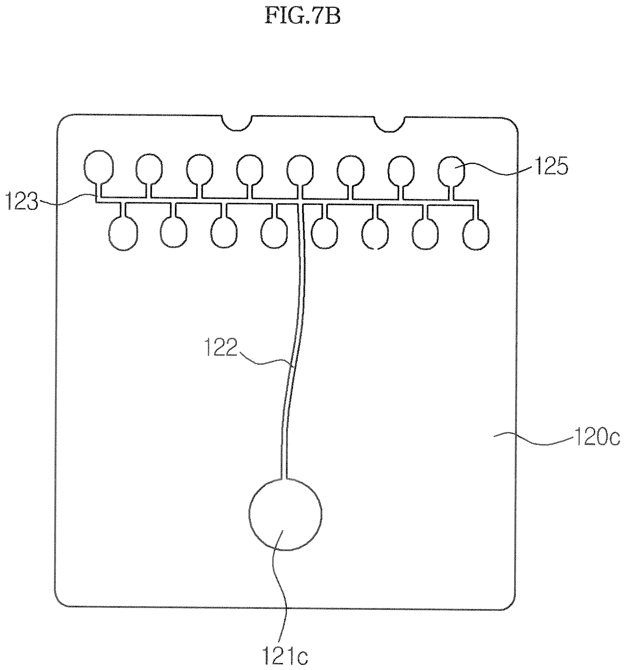

Alternatively, as shown in FIG. 7B, the supply channel 122 may be connected to the branch channel 123, instead of being directly connected to one of the plurality of inspection chambers 125.

As described above, depending on the type of fluid sample and/or the type of inspection performed in each of the plurality of inspection chambers 125, the supply channel 122 may be connected to one of the plurality of inspection chambers 125, or may be connected to the branch channel 123.

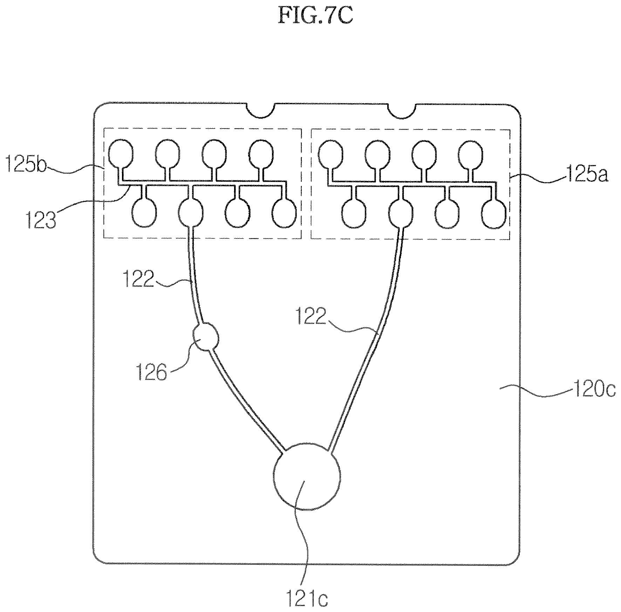

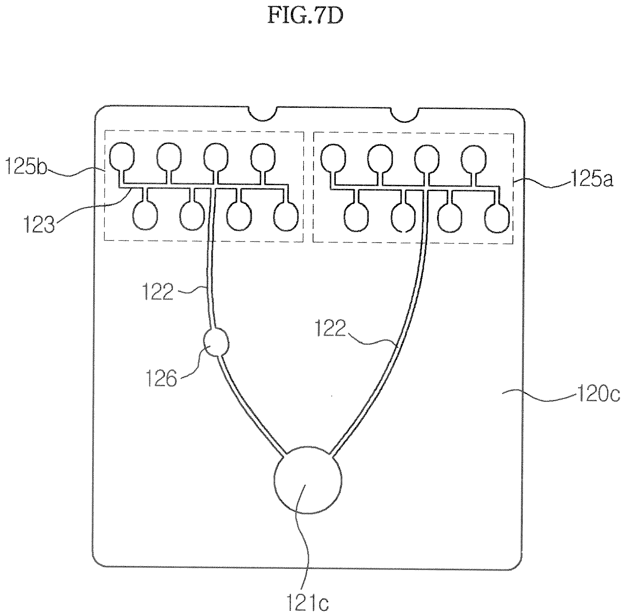

As shown in FIGS. 7C and 7D, the plurality of inspection chambers 125, having a configuration in which the upper chamber alternates with the lower chamber, may be divided into two inspection regions. In this case, two supply channels 122 corresponding to the divided inspection regions (125a, 125b) may be provided. The two supply channels 122 may connect the inlet 121c to each inspection region, and one of the supply channels 122 may pass through an intermediate chamber 126 disposed between the inlet 121c and the inspection region 125b to enable the fluid sample to be pre-treated or undergo primary reaction therein. Alternatively, a plurality of intermediate chambers 126, each corresponding to each of the two supply channels 122 may be provided to enable different pre-treatments or different primary reactions.

Similarly, in FIGS. 7A to 7D, transparent regions in the upper plate 120a and the lower plate 120b may be formed in regions corresponding to and in alignment with the plurality of inspection chambers 125.

In the exemplary embodiments described in FIGS. 6A to 7D, as the radius of curvature of the supply channel 122 increases (i.e., the supply channel 122 is further bent), speed of the fluid sample flowing therein decreases. Similarly, as the radius of curvature of the supply channel 122 decreases (i.e., the supply channel 122 becomes straighter), the speed of the fluid sample flowing therein increases. Accordingly, the supply channel 122 may be formed by suitably setting a bending level depending on the type of fluid sample or the type of inspection. When two or more supply channels 122 are formed, fluid samples may be supplied to two or more inspection regions at predetermined time intervals by configuring the bending levels (i.e., radii of curvature of each supply channel 122) thereof at different values.

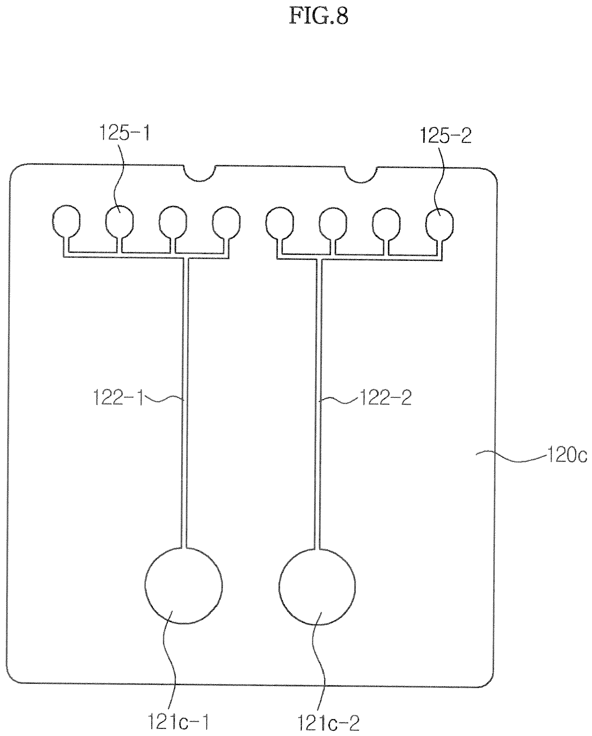

FIG. 8 is a plan view illustrating an exemplary intermediate plate including two inlets.

As described with reference to FIGS. 2B to 2C, the fluid analysis cartridge 100 may include two or more supply holes 111a. When the fluid supplier 111 of the housing 110 includes two or more supply holes 111a, the inspection unit 120 may also include two or more inlets 121. For example, when the fluid supplier 111 includes two supply holes 111a, as shown in FIG. 2B, the intermediate plate 120c may also include two inlets 121c-1 and 121c-2, as shown in FIG. 8. Also, although not shown in the drawings, the upper plate 120a may also include two inlets at positions corresponding thereto.

The fluid samples supplied through the each of the two inlets 121c-1 and 121c-2 may be different types of fluid samples. The supply channels 122-1 and 122-2 connected to the respective inlets may independently supply separate inspection chambers 125-1 and 125-2, respectively.

In an exemplary embodiment, as shown in FIG. 8, the inspection chamber 125-1 connected to the first inlet 121c-1 through the first supply channel 122-1 may contain reagents used for blood inspection, while the inspection chamber 125-2 connected to the second inlet 121c-2 through the second supply channel 122-2 may contain reagents used for tissue fluid inspection. Thus, such a configuration enables inspection of two different types of fluid samples in one fluid analysis cartridge 100.

Alternatively, the plurality of inspection chambers 125-1 connected to the first inlet 121c-1 and the plurality of inspection chambers 125-2 connected to the second inlet 121c-2 may contain the same reagents. Thus, blood collected from different patients or objects may independently be supplied through the first inlet 121c-1 and the second inlet 121c-2 for analysis.

Although formation of two inlets on the intermediate plate 120c is illustrated in FIG. 8, three or more supply holes 111a may be formed as described above in reference to FIG. 2C and three or more inlets 121c may be formed in the intermediate plate 120c. Thus, it should be understood that the inlet 121a formed in the upper plate 120a corresponds to the inlet 121c of the intermediate plate 120c, both of which correspond to and are in alignment with the supply hole 111a.

Also, when two inlets are formed, all the structures described above with reference to FIGS. 6A to 7D may be applied. Specifically, the plurality of inspection chambers 125-1 and 125-2 may have a multi-layered structure, or the plurality of inspection chambers may be provided as an alternating array of upper and lower layers. In addition, two or more supply channels may be connected to any one of both of inlets 121c-1 and 121c-2.

As is apparent from the above description, it is possible to improve user convenience and inspect a plurality of fluid samples using one cartridge.

In addition, the fluid analysis cartridge provided herein makes it possible to separate a specific substance via a polymer membrane, which may be coated or filled with a functional substance. In addition, the fluid analysis cartridge makes it possible to perform multiple analyses using one cartridge by forming a variety of structures of an analysis unit to independently analyze supplied fluids.

Further examples referring to the invention are:
1. An inspection unit 120 to receive and inspect a fluid sample comprising:
   a plurality of inspection chambers 125 to inspect the received fluid sample,
   wherein the inspection chambers 125 are disposed in an arrangement to form a double-layer structure, and an upper layer of inspection chambers alternates with a lower layer of inspection chambers.
2. The inspection unit according to example 1, further comprising:
   an inlet 121 through which the fluid sample is supplied; and
   at least one supply channel 122 to supply the fluid sample from the inlet 121 to the inspection chambers 125.
3. The inspection unit according to example 2, wherein the inspection chambers 125 are divided into at least two inspection regions 125-1, 125-2,
   the supply channel 122 comprises at least two supply channels 122-1, 122-2 to connect the respective inspection regions 125-1, 125-2 to the inlet 121,
   the two or more supply channels 122-1, 122-2 have different radii of curvature relative to each other, and
   the inspection unit 120 further comprises an intermediate chamber 126 disposed between the inlet 121 and the inspection region 125, wherein one of the supply channels 122 passes through the intermediate chamber 126.
4. An inspection unit 120 to receive and inspect a fluid sample comprising:
   an inlet 121 through which the fluid sample is supplied;
   a plurality of inspection chambers 125 to inspect the supplied fluid sample; and
   a supply channel 122 to connect the inlet 121 to the inspection chambers 125,
   wherein the inspection chambers 125 are divided into at least two inspection regions 125-1, 125-2 and the supply channel 122 comprises at least two supply channels 122-1, 122-2 to connect the respective inspection regions 125-1, 125-2 to the inlet 121.
5. The inspection unit according to example 4, wherein the at least two supply channels 122-1, 122-2 connect the inlet 121 to one of the inspection chambers 125, and
   the at least two supply channels 122-1, 122-2 have different radii of curvature relative to each other.
6. A fluid analysis cartridge 100 to inspect a fluid sample comprising:
   an inspection unit 120 to receive the fluid sample and perform a plurality of inspections on the fluid sample; and
   a housing 110 comprising at least one supply hole 111a to supply the fluid sample to the inspection unit 120,
   wherein the inspection unit 120 comprises an upper plate 120a, a lower plate 120b, and an intermediate plate 120c inserted between the upper plate 120a and the lower plate 120b, wherein each of the upper and lower plates 120a, 120b is form from a film, the intermediate plate 120c is formed from a porous sheet, and the upper, intermediate, and lower plates 120a, 120b, 120c are bonded to one another.
7. The fluid analysis cartridge according to example 6, wherein the intermediate plate 120c comprises:
   an inlet 121 through which the fluid sample is supplied from the supply hole 111a;
   a plurality of inspection chambers 125 to inspect the fluid sample supplied through the inlet 121; and
   a supply channel 122 to connect the inlet 121 to the inspection chambers 125.

## Claims

1. A fluid analysis cartridge (100) to inspect a fluid sample comprising:
an inspection unit (120) to receive and inspect the fluid sample;
a housing (110) comprising at least one supply hole (111a) to supply the fluid sample to the inspection unit (120); and
a filtering unit (130) disposed between the inspection unit (120) and the housing (110) at a position corresponding to the supply hole (111a) of the housing, and configured to filter a specific substance present in the fluid sample, wherein the filtering unit (130) comprises two or more porous membranes (130 a, b, c), each having a plurality of pores and being configured to filter a substance larger in size than the sizes of the plurality of pores,
**characterized in that**
a functional substance (131) which reacts with, bonds to, or absorbes the specific substance is disposed between each of the two or more layers of porous membranes (130a, 130b, 130c).

2. The fluid analysis cartridge according to claim 1, wherein a bottom surface of the housing (110) is bonded to an upper surface of the inspection unit (120),
the inspection unit (120) comprises an inlet (121) through which the fluid sample is supplied from the supply hole (111a), and
the housing (110) is bonded to the inspection unit (120) such that the supply hole (111a) is in alignment with the inlet (121).

3. The fluid analysis cartridge according to claim 1or 2, wherein the filtering unit (130) comprises a membrane (130 a, b, c) surface-coated with the functional substance (131) which reacts with, bonds to, or absorbs the specific substance.

4. The fluid analysis cartridge according to claim 2 or 3, wherein the inspection unit (120) comprises:
a plurality of inspection chambers (125) configured to inspect the fluid sample supplied through the inlet (121); and
a supply channel (122) configured to connect the inlet (121) to the plurality of inspection chambers (125).

5. The fluid analysis cartridge according to one of the previous claims 2 to 4, wherein the inspection unit (120) comprises an upper plate (120a), a lower plate (120b), and an intermediate plate (120c) inserted between the upper and lower plates (120a, 120b),
the upper and lower plates (120 a, b) comprising a film, and the intermediate plate (120c) comprising a porous sheet,
the inlet (121), the inspection chambers (125) and the supply channel (122) are formed in the intermediate plate (120c), and
the upper plate (120a) and the lower plate (120b) are printed with a light-shielding ink, and regions (125 a, b) of the upper plate (120a) and the lower plate (120b) corresponding to the inspection chambers (125) are treated with a transparent material.

6. The fluid analysis cartridge according to one of the previous claims 2 to 5 wherein the housing (110) comprises two or more supply holes (111a) and the inspection unit (120) comprises two or more inlets (125) at positions corresponding to and in alignment with the supply holes (111a).

## Patentansprüche

1. Fluidanalyse-Kartusche (100) zum Prüfen einer Fluid-Probe, die umfasst:
eine Prüf-Einheit (120) zum Aufnehmen und Prüfen der Fluid-Probe;
ein Gehäuse (110), das wenigstens eine Zuführ-Öffnung (111a) zum Zuführen der Fluid-Probe zu der Prüf-Einheit (120) umfasst; und
eine Filter-Einheit (130), die zwischen der Prüf-Einheit (120) und dem Gehäuse (110) an einer Position angeordnet ist, die der Zuführ-Öffnung (111a) des Gehäuses entspricht, und die so eingerichtet ist, dass sie eine bestimmte, in der Fluid-Probe vorhandene Substanz filtert, wobei die Filter-Einheit (130) 2 oder mehr poröse Membranen (130a, b, c) umfasst, die jeweils eine Vielzahl von Poren aufweisen und so eingerichtet sind, dass sie eine Substanz filtern, die größer ist als die Größe der Vielzahl von Poren,
**dadurch gekennzeichnet, dass**
eine funktionale Substanz (131), die mit der bestimmten Substanz reagiert, mit ihr eine Bindung eingeht oder sie absorbiert, zwischen jeder der zwei oder mehr Schichten poröser Membranen (130a, 130b, 130c) angeordnet ist.

2. Fluidanalyse-Kartusche nach Anspruch 1, wobei eine untere Fläche des Gehäuses (110) mit einer oberen Fläche der Prüf-Einheit (120) verbunden ist,
die Prüf-Einheit (120) einen Einlass (121) umfasst, durch den die Fluid-Probe über die Zuführ-Öffnung (111a) zugeführt wird, und
das Gehäuse (110) so mit der Prüf-Einheit (120) verbunden ist, dass die Zuführ-Öffnung (111a) auf den Einlass (121) ausgerichtet ist.

3. Fluidanalyse-Kartusche nach Anspruch 1 oder 2, wobei die Filter-Einheit (130) eine Membran (130a, b, c) umfasst, die mit der funktionalen Substanz (131) oberflächenbeschichtet ist, die mit der bestimmten Substanz reagiert, mit ihr eine Bindung eingeht oder sie absorbiert.

4. Fluidanalyse-Kartusche nach Anspruch 2 oder 3, wobei die Prüf-Einheit (120) umfasst:
eine Vielzahl von Prüf-Kammern (125), die zum Prüfen der über den Einlass (121) zugeführten Fluid-Probe eingerichtet sind; sowie
einen Zuführ-Kanal (122), der so eingerichtet ist, dass er den Einlass (121) mit der Vielzahl von Prüf-Kammern (125) verbindet.

5. Fluidanalyse-Kartusche nach einem der vorangehenden Ansprüche 2 bis 4, wobei die Prüf-Einheit (120) eine obere Platte (120a), eine untere Platte (120b) sowie eine Zwischen-Platte (120c) umfasst, die zwischen die obere und die untere Platte (120a, 120b) eingesetzt ist,
die obere und die untere Platte (120a, b) eine Folie umfassen und die Zwischen-Platte (120c) eine poröse Dünnschicht umfasst,
der Einlass (121), die Prüf-Kammern (125) und der Zuführ-Kanal (122) in der Zwischen-Platte (120c) ausgebildet sind, und
die obere Platte (120a) sowie die untere Platte (120b) mit einer lichtabschirmenden Farbe bedruckt sind und Bereiche (125a, b) der oberen Platte (120a) und der unteren Platte (120b), die den Prüf-Kammern (125) entsprechen, mit einem transparenten Material behandelt sind.

6. Fluidanalyse-Kartusche nach einem der vorangehenden Ansprüche 2 bis 5, wobei das Gehäuse (110) zwei oder mehr Zuführ-Öffnungen (111a) umfasst und die Prüf-Einheit (120) zwei oder mehr Einlasse (125) an Positionen umfasst, die den Zuführ-Öffnungen (111a) entsprechen und auf sie ausgerichtet sind.

## Revendications

1. Cartouche d'analyse de fluide (100) pour inspecter un échantillon de fluide comprenant :
une unité d'inspection (120) pour recevoir et inspecter l'échantillon de fluide ;
un boîtier (110) comprenant au moins un trou d'alimentation (111a) pour alimenter l'échantillon de fluide dans l'unité d'inspection (120) ; et
une unité de filtrage (130) disposée entre l'unité d'inspection (120) et le boîtier (110) à une position correspondant au trou d'alimentation (111a) du boîtier, et configurée pour filtrer une substance spécifique présente dans l'échantillon de fluide, dans laquelle l'unité de filtrage (130) comprend deux ou plus de deux membranes poreuses (130 a, b, c), chacune ayant une pluralité de pores et étant configurée pour filtrer une substance dont la taille est supérieure aux tailles de la pluralité de pores, **caractérisée en ce que**
une substance fonctionnelle (131) qui réagit avec, se lie à, ou absorbe la substance spécifique est disposée entre chacune des deux ou plus de deux couches de membranes poreuses (130a, 130b, 130c).

2. Cartouche d'analyse de fluide selon la revendication 1, dans laquelle une surface inférieure du boîtier (110) est liée à une surface supérieure de l'unité d'inspection (120),
l'unité d'inspection (120) comprend une entrée (121) à travers laquelle l'échantillon de fluide est alimenté à partir du trou d'alimentation (111a), et
le boîtier (110) est lié à l'unité d'inspection (120) de telle sorte que le trou d'alimentation (111a) est aligné avec l'entrée (121).

3. Cartouche d'analyse de fluide selon la revendication 1 ou 2, dans laquelle l'unité de filtrage (130) comprend une membrane (130 a, b, c) revêtue en surface par la substance fonctionnelle (131) qui réagit avec, se lie à, ou absorbe la substance spécifique.

4. Cartouche d'analyse de fluide selon la revendication 2 ou 3, dans laquelle l'unité d'inspection (120) comprend :
une pluralité de chambres d'inspection (125) configurées pour inspecter l'échantillon de fluide alimenté à travers l'entrée (121) ; et
un canal d'alimentation (122) configuré pour connecter l'entrée (121) à la pluralité de chambres d'inspection (125).

5. Cartouche d'analyse de fluide selon l'une des revendications précédentes 2 à 4, dans laquelle l'unité d'inspection (120) comprend une plaque supérieure (120a), une plaque inférieure (120b), et une plaque intermédiaire (120c) insérée entre les plaques supérieure et inférieure (120a, 120b),
les plaques supérieure et inférieure (120 a, b) comprenant un film, et la plaque intermédiaire (120c) comprenant une feuille poreuse,
l'entrée (121), les chambres d'inspection (125) et le canal d'alimentation (122) sont formés dans la plaque intermédiaire (120c), et
la plaque supérieure (120a) et la plaque inférieure (120b) sont imprimées avec une encre protégeant de la lumière, et des régions (125 a, b) de la plaque supérieure (120a) et de la plaque inférieure (120b) correspondant aux chambres d'inspection (125) sont traitées à l'aide d'un matériau transparent.

6. Cartouche d'analyse de fluide selon l'une des revendications précédentes 2 à 5, dans laquelle le boîtier (110) comprend deux ou plus de deux trous d'alimentation (111a) et l'unité d'inspection (120) comprend deux ou plus de deux entrées (125) à des positions correspondant aux trous d'alimentation (111a) et en alignement avec ceux-ci.
